# EUROPÄISCHE PATENTSCHRIFT

(11) **EP 0 926 270 B1**
(45) Veröffentlichungstag und Bekanntmachung des Hinweises auf die Patenterteilung: **20.03.2002**
(21) Anmeldenummer: 98123048.5
(22) Anmeldetag: 08.12.1998
(51) Int. Cl.: C30B 15/14

(54) **Verfahren und Vorrichtung zur Herstellung eines Einkristalls**
Process and apparatus for producing a single crystal
Procédé et appareillage pour la fabrication d'un monocristal

(30) Priorität: 18.12.1997 DE 19756613
(43) Veröffentlichungstag der Anmeldung: 30.06.1999
(73) Patentinhaber: Wacker Siltronic Gesellschaft für Halbleitermaterialien Aktiengesellschaft, 84489 Burghausen (DE)
(72) Erfinder: von Ammon, Wilfried, Dr., 5122 Hochburg/Ach (AT); Tomzig, Erich, Dr., 84508 Burgkirchen (DE); Virbulis, Janis, Dr., 84489 Burghausen (DE)
(74) Vertreter: Rimböck, Karl-Heinz, Dr.

(56) Entgegenhaltungen:
- EP-A- 0 811 707
- EP-A- 0 866 150
- WO-A-92/18672
- DE-A- 19 806 045
- FR-A- 1 316 707
- US-A- 2 852 420
- US-A- 4 597 949
- PATENT ABSTRACTS OF JAPAN vol. 018, no. 244 (P-1734), 10. Mai 1994 & JP 06 027684 A (TOKYO OHKA KOGYO CO LTD), 4. Februar 1994
- PATENT ABSTRACTS OF JAPAN vol. 7, no. 118 (C-167) [1263], 21. Mai 1983 & JP 58 036998 A (TOSHIBA CERAMICS KK), 4. März 1983
- PATENT ABSTRACTS OF JAPAN vol. 018, no. 575 (C-1268), 4. November 1994 & JP 06 211591 A (NIPPON STEEL CORP;OTHERS: 01), 2. August 1994
- PATENT ABSTRACTS OF JAPAN Bd. 009, Nr. 145 (C-287) 20 Juni 1985 & JP 60 027 684 A (FUJITSU KK) 12 Februar 1985
- DATABASE WPI Week 8512, Derwent Publications Ltd., London, GB; Class J04, AN 1985-072441, XP002946463 'Single crystal prodn. appts.' & JP 60 027 684 A (FUJITSU LTD.) 12 Februar 1985

## Beschreibung

Gegenstand der Erfindung sind ein Verfahren und eine Vorrichtung zur Herstellung eines Einkristalls aus Halbleitermaterial durch Ziehen des Einkristalls aus einer Schmelze, die sich in einem Tiegel befindet und von einem Seitenheizer erhitzt wird, der den Tiegel umgibt.

Diese Art der Herstellung von Einkristallen ist unter dem Begriff Czochralski-Methode bekannt und Gegenstand anhaltender Untersuchungen. In der JP-60-022684 A ist ein Verfahren beschrieben, mit dem mit Hilfe einer über der Schmelze angeordneten Heizvorrichtung der Sauerstoffgehalt im Einkristall verringert werden kann. Es ist auch bereits bekannt, daß das Auftreten bestimmter Defektarten im gewachsenen Einkristall von der Ziehgeschwindigkeit V und dem axialen Temperaturgradienten G an der Phasengrenze von Einkristall und Schmelze abhängig ist. Wenn die Bedingungen während des Ziehens des Einkristalls derart sind, daß die Gleichung V/G < C_{crit} erfüllt ist, wobei C_{crit} eine Konstante ist, bilden sich mehrheitlich Zwischengitterdefekte, sogenannte "large pits", aus (E.Domberger, W. v. Ammon in Electrochemical Society, Vol.143, No.5 (1996)). Diese Defektart, nachfolgend L-Defekte genannt, kann die Ausbeute an funktionierenden elektronischen Bauelementen, die durch Weiterverarbeitung des Einkristalls hergestellt werden, erheblich beeinträchtigen. Die angegebene Gleichung legt nahe, daß zur Vermeidung des Auftretens von L-Defekten möglichst hohe Ziehgeschwindigkeiten anzustreben sind.

Beim Ziehen eines Einkristalls stellt man jedoch auch fest, daß die Ziehgeschwindigkeit nur bis zu einem gewissen Grad gesteigert werden kann, ohne daß sich dadurch das Wachstumsverhalten des Einkristalls unakzeptabel verändert. Der Einkristall beginnt nämlich bei zu hohen Ziehgeschwindigkeiten, das gewünschte zylindrische Wachstum aufzugeben und unrund zu wachsen, das heißt, statt einer zylindrischen Mantelfäche ebene Kristallflächen entsprechend seiner kristallographischen Orientierung auszubilden. Darüber hinaus erhöht ein unrundes Wachstum die Gefahr der Erzeugung von Kristallgitterstörungen, die das gezogene Material unbrauchbar machen.

Die vorliegende Erfindung zeigt einen Weg auf, wie erreicht werden kann, daß der Übergang von einem zylindrischen Wachstum zu einem unrunden Wachstum erst bei höheren Ziegeschwindigkeiten als bisher üblich erfolgt.

Gegenstand der Erfindung ist ein Verfahren gemäß Anspruch 1.

Das Verfahren erweitert den Zugang zu zylindrisch geformten Einkristallen, die weitgehend frei von L-Defekten sind. Es ist besonders vorteilhaft, es zur Herstellung von Einkristallen aus Silicium mit großen Durchmessern, beispielsweise mit Durchmessern von 200 mm, 300 mm oder 400 mm, einzusetzen.

Zur Durchführung des Verfahrens wird eine Vorrichtung gemäß Anspruch 5 mit einer ringförmigen Heizvorrichtung vorgeschlagen.

Die ringförmige Heizvorrichtung wird vorteilhafterweise so über der Schmelze angeordnet, daß der Abstand zwischen dem Einkristall und der Heizvorrichtung kürzer ist als der Abstand zwischen der Heizvorrichtung und der Tiegelwand. Besonders bevorzugt ist, daß der Abstand zum Einkristall möglichst gering ist und beispielsweise nur 3 cm beträgt. Weiterhin ist bevorzugt, die Heizvorrichtung am unteren Rand eines thermisch isolierenden Hitzeschildes zu befestigen, der den Einkristall gegen Wärmestrahlung des Seitenheizers abschirmt. Es ist darauf zu achten, daß die Heizvorrichtung nur die Schmelze und nicht den Einkristall erhitzt. Gegebenenfalls sollte daher eine thermische Isolierung, beispielsweise der Hitzeschild, zwischen dem Einkristall und der Heizvorrichtung vorgesehen sein. Der Abstand zwischen der ringförmigen Heizvorrichtung und der Oberfläche der Schmelze liegt vorzugsweise bei 10 bis 20 mm.

Die ringförmige Heizvorrichtung erhitzt die Schmelze in einem oberflächennahen Bereich, der um den Einkristall herum liegt. Sie erzeugt dadurch in der Schmelze zwischen dem Einkristall und dem Tiegel einen steilen, axialen Temperaturgradienten, der ein zylindrisches Wachstum des Einkristalls fördert.

Die ringförmige Heizvorrichtung kann darüber hinaus eingesetzt werden, um einen Teil der zur Erzeugung der Schmelze benötigten Energie zu liefern und die zum Schmelzen des Halbleitermaterials benötigte Zeit zu verkürzen. Bevorzugt ist auch, daß die Heizleistung des Seitenheizers und gegebenenfalls die eines Bodenheizers, der unter dem Tiegel angeordnet ist, vermindert wird, wenn die Schmelze durch die ringförmige Heizvorrichtung zusätzlich erhitzt wird. Auf diese Weise kann das Tiegelmaterial, das üblicherweise aus Quarzglas besteht und von der heißen Schmelze angegriffen wird, gegen frühzeitige Korrosion geschützt werden. Die herabgesetzte Geschwindigkeit der Korrosion des Tiegels wirkt sich auch günstig auf die Ausbeute an einkristallinem Halbleitermaterial aus.

Weiterhin kann die ringförmige Heizvorrichtung wegen ihrer geringen thermischen Masse auch bevorzugt zur schnellen Leistungsregelung, die ihrerseits das Durchmesserwachstum und die Ziehgeschwindigkeit beeinflusst, verwendet werden. Dadurch lassen sich Durchmesser- und Ziehgeschwindigkeitsschwankungen deutlich reduzieren.

Die Erfindung kann schließlich auch eingesetzt werden, um den Sauerstoffgehalt in der Schmelze und folglich auch im Einkristall zu kontrollieren, indem die Heizleistung variiert wird. Das Erhöhen der Heizleistung der ringförmigen Heizvorrichtung begünstigt das Entweichen von SiO durch die Oberfläche der Schmelze, während die Heizleistung des Seitenheizers und gegebenenfalls die des Bodenheizers herabgesetzt werden kann, was die Korrosion des Quarzglas vermindert. Auf diese Weise wird die Konzentration von Sauerstoff in der Schmelze herabgesetzt und weniger Sauerstoff in den Einkristall eingebaut.

Die Erfindung wird nachfolgend anhand von Figuren näher erläutert.
Figur 1 zeigt schematisch eine erste Ausführungsform der Erfindung.
Figur 2 zeigt schematisch eine zweite, bevorzugte Ausführungsform der Erfindung.

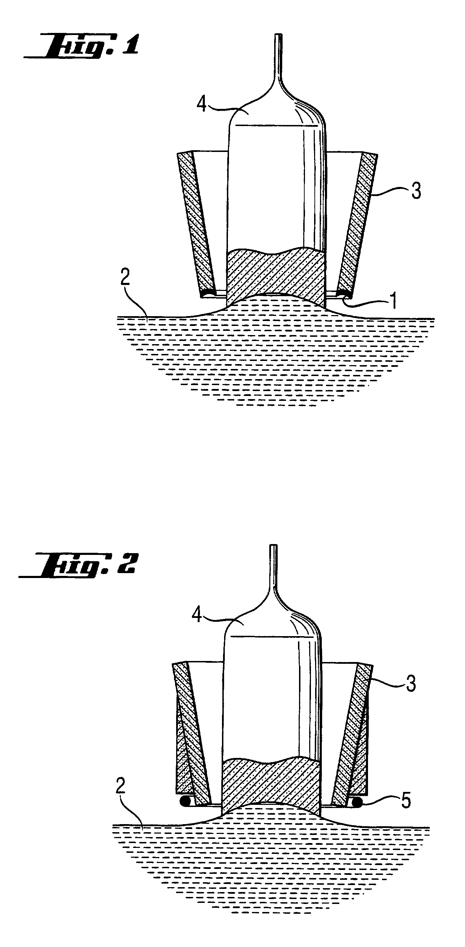

Gemäß der Ausführungsform der Erfindung, die in Fig. 1 dargestellt ist, ist die ringförmige Heizvorrichtung als Reflektor 1 ausgebildet, der über der Schmelze 2 am unteren Rand einer thermischen Isolierung 3 befestigt ist und Wärmestrahlung in Richtung auf die Schmelze reflektiert. Der Reflektor ist mit geringem Abstand zum Einkristall 4 um den Einkristall herum angeordnet. Durch die reflektierte Wärmestrahlung wird die Schmelze in einem ringförmigen Bereich um den Einkristall herum erhitzt.

Die ringförmige Heizvorrichtung kann auch, wie dies in Fig. 2 dargestellt ist, als aktiver Heizer 5 ausgebildet sein. Dies kann ein Widerstandsheizer sein, der beispielsweise aus Graphit oder Molybdän gefertigt ist, oder ein mit hochfrequentem Wechselstrom betriebener Induktionsheizer. Letztgenannter besteht vorzugsweise aus einem hochtemperaturbeständigen, elektrisch hochleitfähigen Material, beispielsweise aus Molybdän, Wolfram oder Tantal, oder ist als wassergekühltes Kupfer- oder Silberrohr ausgebildet.

## Patentansprüche

1. Verfahren zur Herstellung eines Einkristalls aus Halbleitermaterial durch Ziehen des Einkristalls aus einer Schmelze, die sich in einem Tiegel befindet und von einem, den Tiegel umgebenden Seitenheizer und von einer über der Schmelze angeordneten, ringförmigen und den Einkristall umgebenden Heizvorrichtung erhitzt wird, **dadurch gekennzeichnet, daß** darauf geachtet wird, daß die Heizvorrichtung die Schmelze und nicht den Einkristall erhitzt, und der Abstand zwischen dem Einkristall und der Heizvorrichtung kürzer ist, als der Abstand zwischen der Heizvorrichtung und der Tiegelwand.

2. Verfahren nach Anspruch 1, **dadurch gekennzeichnet, daß** die Heizleistung des Seitenheizers und gegebenenfalls eines Bodenheizers vermindert wird, wenn die Schmelze durch die ringförmige Heizvorrichtung zusätzlich erhitzt wird.

3. Verfahren nach Anspruch 1, **dadurch gekennzeichnet, daß** vor dem Ziehen des Einkristalls die Schmelze erzeugt wird und ein Teil der dafür benötigten Wärme durch die ringförmige Heizvorrichtung bereitgestellt wird.

4. Verfahren nach einem der Ansprüche 1 bis 3, **dadurch gekennzeichnet, daß** die ringförmige Heizvorrichtung zur schnellen Regelung der Heizleistung eingesetzt wird.

5. Vorrichtung zum Ziehen eines Einkristalls aus Halbleitermaterial, umfassend einen Tiegel, eine im Tiegel befindliche Schmelze, einen aus der Schmelze aufragenden Einkristall, und eine ringförmige Heizvorrichtung zum Erhitzen der Schmelze, die den Einkristall umgibt und derart über der Schmelze angeordnet ist, daß ein ringförmiger Bereich der Schmelze und nicht der Einkristall erhitzt wird, **dadurch gekennzeichnet, daß** die ringförmige Heizvorrichtung derart angeordnet ist, daß sie sich näher beim Einkristall als bei einer Wand des Tiegels befindet.

6. Vorrichtung nach Anspruch 5, **dadurch gekennzeichnet, daß** die ringförmige Heizvorrichtung ein Widerstandsheizer ist, der Wärmestrahlung in Richtung auf die Schmelze abstrahlt.

7. Vorrichtung nach Anspruch 5, **dadurch gekennzeichnet, daß** die ringförmige Heizvorrichtung ein Induktionsheizer ist, der die Schmelze im ringförmigen Bereich um den Einkristall herum induktiv erhitzt.

8. Vorrichtung nach einem der Ansprüche 5 bis 8, **dadurch gekennzeichnet, daß** die ringförmige Heizvorrichtung an einem unteren Rand eines Hitzeschildes befestigt ist, der den Einkristall thermisch abschirmt.

9. Vorrichtung nach einem der Ansprüche 5 bis 9, **gekennzeichnet durch** eine thermische Isolierung zwischen dem Einkristall und der ringförmigen Heizvorrichtung.

10. Verfahren nach einem der Ansprüche 1 bis 4, **dadurch gekennzeichnet, daß** der Sauerstoffgehalt im wachsenden Einkristall kontrolliert wird, indem die Heizleistung der ringförmigen Heizvorrichtung, die des Seitenheizers und gegebenenfalls die des Bodenheizers angepaßt wird.

## Claims

1. Process for the production of a single crystal of semiconductor material by pulling the single crystal from a melt, which is contained in a crucible and is heated by a side heater surrounding the crucible and by an annular heating device which surrounds the single crystal and is arranged above the melt, **characterized in that** it is ensured that the heating device heats the melt and not the single crystal, and the distance between the single crystal and the heating device is less than the distance between the heating device and the wall of the crucible.

2. Process according to Claim 1, **characterized in that** the heating power of the side heater and, where appropriate, a bottom heater, is reduced when the melt is additionally heated by the annular heating device.

3. Process according to Claim 1, **characterized in that** the melt is produced before the single crystal is pulled, and part of the heat needed for this is provided by the annular heating device.

4. Process according to one of Claims 1 to 3, **characterized in that** the annular heating device is used for rapid control of the heating power.

5. Device for pulling a single crystal of semiconductor material, comprising a crucible, a melt contained in the crucible, a single crystal projecting from the melt, and an annular heating device for heating the melt, which surrounds the single crystal and is arranged above the melt in such a way that an annular region of the melt and not the single crystal is heated, **characterized in that** the annular heating device is arranged in such a way that it is situated closer to the single crystal than to a wall for the crucible.

6. Device according to Claim 5, **characterized in that** the annular heating device is a heating resistor which radiates heat radiation towards the melt.

7. Device according to Claim 5, **characterized in that** the annular heating device is an induction heater which inductively heats the melt in the annular region around the single crystal.

8. Device according to one of Claims 5 to 8, **characterized in that** the annular heating device is fastened to a lower edge of a heat shield which thermally screens the single crystal.

9. Device according to one of Claims 5 to 9, **characterized by** thermal insulation between the single crystal and the annular heating device.

10. Process according to one of Claims 1 to 4, **characterized in that** the oxygen content in the growing single crystal is controlled by adapting the heating power of the annular heating device, that of the side heater and, where appropriate, that of the bottom heater.

## Revendications

1. Procédé de préparation d'un monocristal en matériau semi-conducteur par étirage du monocristal à partir d'une masse fondue, qui se trouve dans un creuset et qui est chauffée par un dispositif de chauffage latéral entourant le creuset et par un dispositif de chauffage annulaire, entourant le monocristal et disposé au-dessus de la masse fondue, **caractérisé en ce que** l'on veille à ce que le dispositif de chauffage chauffe la masse fondue et non pas le monocristal et **en ce que** la distance entre le monocristal et le dispositif de chauffage est plus courte que la distance entre le dispositif de chauffage et la paroi du creuset.

2. Procédé selon la revendication 1, **caractérisé en ce que** la puissance de chauffage du dispositif de chauffage latéral et, le cas échéant, d'un dispositif de chauffage de fond, est réduite quand la masse fondue est chauffée en sus par le dispositif de chauffage annulaire.

3. Procédé selon la revendication 1, **caractérisé en ce que** l'on produit la masse fondue avant l'étirage du monocristal et **en ce que** l'on met à disposition une partie de la chaleur nécessaire à cet effet grâce au dispositif de chauffage annulaire.

4. Procédé selon l'une quelconque des revendications 1 à 3, **caractérisé en ce que** le dispositif de chauffage annulaire est utilisé en vue du réglage rapide de la puissance de chauffage.

5. Dispositif d'étirage d'un monocristal en matériau semi-conducteur, comprenant un creuset, une masse fondue se trouvant dans le creuset, un monocristal faisant saillie vers le haut hors de la masse fondue et un dispositif de chauffage annulaire en vue du chauffage de la masse fondue, qui entoure le monocristal et qui est disposé au-dessus de la masse fondue de telle manière qu'une zone annulaire de la masse fondue et non le monocristal soit chauffé(e), **caractérisé en ce que** le dispositif de chauffage annulaire est disposé de telle sorte qu'il se trouve plus proche du monocristal que d'une paroi du creuset.

6. Dispositif selon la revendication 5, **caractérisé en ce que** le dispositif de chauffage annulaire est un chauffage à résistance, qui émet un rayonnement calorifique en direction de la masse fondue.

7. Dispositif selon la revendication 5, **caractérisé en ce que** le dispositif de chauffage annulaire est un chauffage par induction, qui chauffe par induction la masse fondue dans la zone annulaire autour du monocristal.

8. Dispositif selon l'une quelconque des revendications 5 à 8, **caractérisé en ce que** le dispositif de chauffage annulaire est fixé à un bord inférieur d'un écran de protection thermique, qui protège le monocristal du point de vue thermique.

9. Dispositif selon l'une quelconque des revendications 5 à 9, **caractérisé par** une isolation thermique entre le monocristal et le dispositif de chauffage annulaire.

10. Procédé selon l'une quelconque des revendications 1 à 4, **caractérisé en ce que** le teneur en oxygène dans le monocristal en cours de croissance est contrôlée en adaptant la puissance de chauffage du dispositif de chauffage annulaire à celle du dispositif de chauffage latéral et, le cas échéant, à celle du dispositif de chauffage de fond.
